# EUROPÄISCHE PATENTSCHRIFT

(11) **EP 0 616 243 B1**
(45) Veröffentlichungstag und Bekanntmachung des Hinweises auf die Patenterteilung: **16.12.1998**
(21) Anmeldenummer: 94101948.1
(22) Anmeldetag: 09.02.1994
(51) Int. Cl.: G02F 1/313, H01L 27/15, H01L 33/00, H01S 3/025, H01S 3/19

(54) **Verfahren zur Herstellung eines kaskadierten optischen Raumschalters und nach diesem Verfahren hergestellter kaskadierter optischer Raumschalter**
Method of manufacturing a cascaded optical space switch and cascaded optical space switch manufactured according to this method
Procédé de fabrication d'un commutateur optique spatial en cascade et commutateur optique spatial en cascade réalisé selon ce procédé

(30) Priorität: 18.02.1993 DE 4304993
(43) Veröffentlichungstag der Anmeldung: 21.09.1994
(73) Patentinhaber: ALCATEL ALSTHOM COMPAGNIE GENERALE D'ELECTRICITE, 75008 Paris (FR)
(72) Erfinder: Schilling, Michael, D-70499 Stuttgart (DE)
(74) Vertreter: Pechhold, Eberhard, Dipl.-Phys.

(56) Entgegenhaltungen:
- PATENT ABSTRACTS OF JAPAN vol. 017, no. 313 (E-1381) 15. Juni 1993 & JP-A-05 029 602 (HITACHI LTD) 5. Februar 1993
- IOOC-ECOC '91. 17TH EUROPEAN CONFERENCE ON OPTICAL COMMUNICATION ECOC '91. 8TH INTERNATIONAL CONFERENCE ON INTEGRATED OPTICS AND OPTICAL FIBRE COMMUNICATION IOOC '91, PARIS, FRANCE, Bd.3, September 1991 Seiten 28 - 31 Janson M et al 'Monolithically integrated 2*2 InGaAsP/InP laser amplifier gate switch arrays'
- ELECTRONICS LETTERS., Bd.27, Nr.23, November 1991, STEVENAGE GB Seiten 2138 - 2140, XP000268347 Aoki M et al 'Novel structure MQW electroabsorption modulator/DFB-laser integrated device fabricated by selective area MOCVD growth'
- GLOBECOM '90: IEEE GLOBAL TELECOMMUNICATIONS CONFERENCE AND EXHIBITION. 'COMMUNICATIONS: CONNECTING THE FUTURE', SAN DIEGO, CA, USA, Bd.2, Dezember 1990 Seiten 1296 - 1300 Thylen L et al 'Switch arrays for photonic switching: status review and prospects'
- MICROWAVE AND OPTICAL TECHNOLOGY LETTERS, Bd.7, Nr.3, 20. Februar 1994 Seiten 132 - 139 Aoki M et al 'New photonic device integration by selective-area MOVPE and its application to optical modulator/laser integration'
- Electronics Letters, vol.31, no.20, 28th September 1995, pages 1779-1781, Stevenage, Herts GB. K.Hamamoto et al: "Insertion-loss-free 2*2 InGaAsP/InP optical switch fabricated using bandgap energy controlled selective MOVPE".

## Beschreibung

Die Erfindung betrifft ein Verfahren gemäß dem Oberbegriff des Patentanspruchs 1 sowie einen nach diesem Verfahren hergestellten optischen Raumschalter.

Ein hochintegrierter optischer Raumschalter ist z.B. aus einem Aufsatz von L. Thylen und P. Granestrand, der auf der Globecom 90, Dezember 1990, in San Diego (USA) öffentlich vorgetragen wurde und auch als Konferenzpapier vorliegt, bekannt. Wie aus den Figuren 4 und 8 dieses Aufsatzes hervorgeht, besteht dieser Raumschalter aus einer sehr großen Zahl von optischen Verzweigungen. Jede Verzweigung enthält, monolithisch integriert, optisch aktive und passive Bereiche, deren Aufbau z.B. der Fig. 7 zu entnehmen ist. In den beiden Armen jeder Verzweigung angeordnete optisch aktive Bereiche dienen der Steuerung eines über den jeweiligen Arm geführten Lichtanteiles.

Die Herstellung der optisch aktiven und der passiven Bereiche der o.g. optischen Verzweigungen auf einem Substrat ist in einer Druckschrift der Fa. Ericsson Telecom AB, Stockholm, Schweden, mit dem Titel "Monolithically Integrated 2 x 2 In Ga As P/InP Laser Amplifier Gate Switch Arrays" ausführlich beschrieben. Sie umfaßt eine Vielzahl von Verfahrensschritten, in denen Schichten aufgewachsen oder selektiv entfernt werden. Die bei der Herstellung angewandten unterschiedlichen Beschichtungs- und Ätzverfahren erfordern die Behandlung des Substrates in verschiedenen Gefäßen und damit dessen mehrfache Umlagerung und Neujustierung.

Der Erfindung liegt die Aufgabe zugrunde, ein Verfahren zur Herstellung eines kaskadierten optischen Raumschalters anzugeben, bei dem der Aufbau sowohl der aktiven als auch der passiven Wellenleiterbereiche in einem einzigen Beschichtungsprozeß erfolgt. Eine Aufgabe der Erfindung ist weiterhin, einen nach diesem Verfahren hergestellten optischen Raumschalter anzugeben.

Die Aufgabe der Erfindung wird hinsichtlich des Verfahrens durch die Merkmale des Patentanspruchs 1, hinsichtlich des nach diesem Verfahren hergestellten optischen Raumschalters durch die Merkmale des Patentanspruchs 5 gelöst. Dabei ist ein die Schichtwachstumsgeschwindigkeit beeinflussender Effekt, der auf bestimmte Bereiche eines Substrates begrenzt werden kann, im Zusammenhang mit der Koppelung eines DFB-Lasers mit einem Elektroabsorptionsmodulator auf einem Substrat bereits bekanntgeworden (siehe z.B. M. Aoki et al. in Electronics Letters 7th Nov. 1991, Vol 27, No. 23, S. 2138 - 2140).

Die Verwendung eines derartigen, die Schichtwachstumsgeschwindigkeit beeinflussenden Effektes, z.B. ein vorheriges Aufbringen einer die örtlich gewünschte Wirksamkeit dieses Effektes bestimmenden dielektrischen Maske, ermöglicht, in unterschiedlichen Bereichen eines aufzuwachsenden Wellenleiters unterschiedliche Schichtdicken und damit ein unterschiedliches Dämpfungs- oder Verstärkungsverhalten für Licht unterschiedlicher Wellenlängen zu erhalten. Durch eine geeignet gestaltete dielektrische Maske können so aktive und passive Wellenleiterbereiche auf einem Substrat erzeugt werden, ohne daß der Beschichtungsvorgang für zwischengeschaltete Ätz- oder Maskierungsschritte unterbrochen werden muß.

Gemäß Patentanspruch 2 kann dies dadurch erfolgen, daß aktive Wellenleiterbereiche als enge, zwischen maskierten Bereichen geführte Kanäle ausgelegt werden, in denen aufgrund der geringen zu beschichtenden Fläche und der demgegenüber großen benachbarten maskierten Flächen ein schnelleres Schichtenwachstum erfolgt als dies auf der übrigen Fläche der Fall ist. Eine gewünschte Geschwindigkeit des Schichtenaufwuchses kann dann durch Vorgabe der Breite der den jeweiligen Wellenleiterbereichen benachbarten, maskierten Bereiche eingestellt werden. Passive Bereiche können gemäß Anspruch 3 ohne flankierende dielektrische Maskierung bleiben oder können gemäß Anspruch 4 beiderseits mit einer Maskierung versehen sein, die jedoch schmäler als die der aktiven Wellenleiterbereiche ausgebildet ist.

Eine nach dem erfindungsgemäßen Verfahren hergestellter optischer Raumschalter ist dem Patentanspruch 5 zu entnehmen.

Anhand von zwei Figuren sollen nachfolgend das Verfahren nach der Erfindung sowie Ausführungsbeispiele von nach diesem Verfahren hergestellten, kaskadierten optischen Raumschaltern ausführlich beschrieben werden.
- Fig. 1: zeigt schematisch die Ausbildung aktiver und passiver Wellenleiterbereiche in einer optischen Verzweigung mit dielektrischer Maskierung entlang der aktiven Wellenleiterbereiche.
- Fig. 2: zeigt eine optische Verzweigung mit durchgehender dielektrischer Maskierung variabler Breite entlang aktiver und passiver Wellenleiterbereiche.

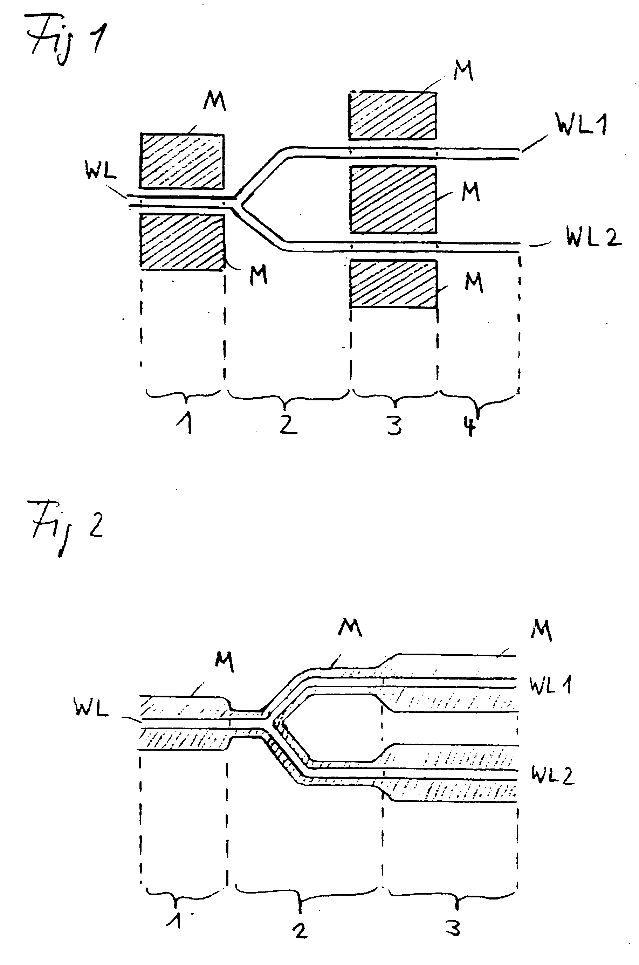

In Figur 1 ist eine optische Verzweigung dargestellt, die durch einen Wellenleiter WL gebildet wird, der sich in zwei Teilwellenleiter WL1 und WL2 aufteilt. Wellenleiter sowie Teilwellenleiter besitzen optisch aktive Bereiche (1, 3), in denen - z.B. abhängig von einem injizierten Strom - hindurchtretendes Licht verstärkt oder gedämpft wird, und passive Bereiche (2, 4), in denen eintretendes Licht unverstärkt weitergeleitet wird. In den Wellenleiter eingestrahltes Licht kann wahlweise in einen oder in beide Teilwellenleiter weitergeleitet werden. Soll Licht vom Wellenleiter WL nur in den Teilwellenleiter WL1 gelangen, so erfolgt dies, wenn der aktive Bereich 3 des Teilwellenleiters WL1 lichtverstärkend oder wenigstens transparent und gleichzeitig der Bereich 3 des Teilwellenleiters WL2 lichtundurchlässig gesteuert wird, vorausgesetzt, daß auch der aktive Bereich 1 des Wellenleiters WL, der z.B. aktiver Bereich eines Teilwellenleiters einer vorgeschalteten optischen Verzweigung sein kann, zumindest transparent gesteuert ist.

Zur Bildung eines kaskadierten optischen Raumschalters werden eine große Zahl von z.B. gemäß Fig. 1 ausgebildeten optischen Verzweigungen auf einem gemeinsamen Substrat erzeugt, wobei jeder Teilwellenleiter jeder Verzweigung in bekannter Weise mit dem Wellenleiter oder einem Teilwellenleiter einer nächsten oder vorausgehenden optischen Verzweigung verbunden ist.

Die in Fig. 1 dargestellte optische Verzweigung besitzt Maskenfelder M, die bereits vor Aufwachsen der den optischen Wellenleiter bildenden Schichten mit einer dielektrischen Schicht (z.B. Si O₂) versehen wurden. Diese Felder sind so angeordnet, daß sie den optischen Wellenleiter entlang seiner aktiven Bereiche zwischen sich einschließen. Die dielektrischen Schichten der Maskenfelder beiderseits des zwischen den Maskenfeldern gelegenen Wellenleiters bewirken dann eine von den Maskenfeldern zum Wellenleiter hin gerichtete Diffusion von zum Aufbau der Wellenleiterschichten benötigter Substanz und damit eine Erhöhung der Schichtwachstumsgeschwindigkeit in dem betroffenen Wellenleiterbereich. Da die Diffusionsraten für einzelne Komponenten der aufzuwachsenden Wellenleiterschichten im allgemeinen unterschiedlich sind, wird auch die Materialzusammensetzung beeinflußt. Beispielsweise erhöht sich der Anteil von Elementen der III. Gruppe in einer III/V Halbleiterschicht. Durch Bemessung der Fläche und Gestalt der Maskenfelder und eventuell zusätzlicher Variation der Breite des Wellenleiters in den unterschiedlichen Bereichen lassen sich das Verhältnis der Dicke der einzelnen Schichten der Wellenleitermesa einschließlich eingelagerter MQW-Schichtpakete zur Dicke der entsprechenden Schichten in passiven Wellenleiterbereichen und damit eine gewünschte Differenz in den für die einzelnen Schichten charakteristischen Bandabstandsenergien einstellen.

Die dielektrischen Schichten der Maskenfelder können nach Aufwachsen der aktiven Schichten des Wellenleiters wieder entfernt werden.

In Fig. 2 ist eine optische Verzweigung dargestellt, bei der alle Wellenleiterbereiche von maskierten Flächen M eingeschlossen sind. Optisch aktive Wellenleiterbereiche 1, 3 unterscheiden sich von passiven Wellenleiterbereichen 2 dadurch, daß hier die maskierten Flächen M breiter sind, was eine höhere Diffusionsrate in Richtung Wellenleiter bewirkt. Auch hier kann zusätzlich die Breite des Wellenleiters variiert werden.

## Patentansprüche

1. Verfahren zur Herstellung eines aus optischen Wellenleitern aufgebauten optischen Raumschalters, der einen Y-förmigen Verzweigungsbereich hat, in dem die optischen Wellenleiter als passive Wellenleiter ausgeführt sind, und der wenigstens zwei weitere unverzweigte Bereiche hat, die sich an den Verzweigungsbereich anschließen und in dem die optischen Wellenleiter als aktive Wellenleiter ausgeführt sind,
**dadurch gekennzeichnet,** daß aktive und passive
Wellenleiterbereiche (1, 3; 2, 4) in einem einzigen Beschichtungsprozeß unter Ausnutzung lokal begrenzbarer, die Schichtwachstumsgeschwindigkeit beeinflussender Effekte aufgewachsen werden.

2. Verfahren nach Anspruch 1, dadurch gekennzeichnet, daß, um die Schichtwachstumsgeschwindigkeit zumindest in den aktiven Wellenleiterbereichen (1, 3) zu beeinflussen, diese zwischen mit einer dielektrischen Schicht maskierten Bereichen (M) der Substratoberfläche angeordnet werden und die Breite des Wellenleiters (WL, WL1, WL2) in den Wellenleiterbereichen und/oder die Fläche der an die Wellenleiterbereiche angrenzenden maskierten Bereiche (M) variiert wird.

3. Verfahren nach Anspruch 2, dadurch gekennzeichnet, daß entlang passiver Wellenleiterbereiche (2, 4) keine Maskierung durch eine dielektrische Schicht vorgesehen ist.

4. Verfahren nach Anspruch 2, dadurch gekennzeichnet, daß die an die Wellenleiterbereiche angrenzenden maskierten Bereiche (M), parallel zur Lichtausbreitungsrichtung im Wellenleiter (WL, WL1, WL2) gesehen, entlang der aktiven Bereiche (1, 3) eine größere und entlang der passiven Bereiche (2, 4) eine geringere Breite besitzen.

5. Aus optischen Wellenleitern aufgebauter optischer Raumschalters, der einen Y-förmigen Verzweigungsbereich hat, in dem die optischen Wellenleiter als passive Wellenleiter ausgeführt sind, und der wenigstens zwei weitere unverzweigte Bereich hat, die sich an den Verzweigungsbereich anschließen und in dem die optischen Wellenleiter als aktive Wellenleiter ausgeführt sind,
**dadurch gekennzeichnet,** daß die aktiven und passiven Wellenleiterbereiche in Lichtausbreitungsrichtung langgestreckte, schmale Teile einer durchgehenden, zusammenhängenden Halbleiterschicht oder eines durchgehenden, zusammenhängenden Halbleiter-Schichtpaketes sind.

## Claims

1. A method of manufacturing an optical space switch composed of optical waveguides, with a Y-shaped branch area wherein the optical waveguides are designed as passive waveguides, and which contains at least two further unbranched areas that are connected to the branched area, and wherein the optical waveguides are designed as active waveguides, characterized in that active and passive waveguide areas (1, 3; 2, 4) are grown in a single coating process which utilizes locally limitable effects that influence the growth rate of the layer.

2. A method as claimed in claim 1, characterized in that, in order to influence the growth rate of the layer at least in the active waveguide areas (1, 3), these are arranged between areas (M) on the substrate surface which are masked with a dielectric layer, and the width of the waveguide (WL, WL1, WL2) varies in the waveguide areas, and/or the size of the masked areas (M) bordering on the waveguide areas varies.

3. A method as claimed in claim 2, characterized in that no masking by means of a dielectric layer is provided along passive waveguide areas (2, 4).

4. A method as claimed in claim 2, characterized in that the masked areas (M) bordering on the waveguide areas are wider along the active areas (1, 3) and narrower along the passive areas (2, 4), when viewed parallel to the direction of light propagation.

5. An optical space switch composed of optical waveguides, with a Y-shaped branch area wherein the optical waveguides are designed as passive waveguides, and which contains at least two further unbranched areas that are connected to the branched area, and in which the optical waveguides are designed as active waveguides, characterized in that in the direction of light propagation the active and passive waveguide areas are narrow lengthy parts of a continuous and contiguous semiconductor layer, or of a continuous and contiguous semiconductor layer packet.

## Revendications

1. Procédé de fabrication d'un commutateur optique formé par des guides d'ondes optiques, qui comprend une zone de ramification en Y, dans laquelle les guides d'ondes optiques sont réalisés sous forme de guides d'ondes passifs et qui comprend au moins deux autres zones non ramifiées, qui font suite à la zone de ramification et dans lesquelles les guides d'ondes optiques sont conçus comme des guides d'ondes actifs, caractérisé en ce que les zones de guides d'ondes actives et passives (1, 3 ; 2, 4) sont déposées en un seul processus de revêtement en exploitant des effets qui peuvent être limités localement et qui influencent la vitesse de croissance des couches.

2. Procédé selon la revendication 1, caractérisé en ce que la vitesse de croissance des couches, au moins dans les zones de guides d'ondes actives (1, 3), est influencée par la disposition desdites zones entre des zones (M) de la surface du substrat, masquées par une couche diélectrique, et par la variation de la largeur du guide d'ondes (WL, WL1, WL2) dans les zones des guides d'ondes et/ou de la surface des zones masquées (M) contiguës aux zones de guides d'ondes.

3. Procédé selon la revendication 2, caractérisé en ce qu'il est prévu de ne pas masquer par une couche diélectrique la partie située le long des zones des guides d'ondes passifs (2, 4).

4. Procédé selon la revendication 2, caractérisé en ce que, vues dans le sens parallèle à la diffusion de la lumière dans le guide d'ondes (WL, WL1, WL2), les zones masquées (M) contiguës aux zones des guides d'ondes sont plus larges le long des zones actives (1, 3) et sont moins larges le long des zones passives (2, 4).

5. Commutateur optique formé par des guides d'ondes optiques, qui comprend une zone de ramification en Y, dans laquelle les guides d'ondes optiques sont réalisés sous forme de guides d'ondes passifs et qui comprend au moins deux autres zones non ramifiées, qui font suite à la zone de ramification et dans lesquelles les guides d'ondes optiques sont conçus comme des guides d'ondes actifs, caractérisé en ce que les zones de guides d'ondes actives et passives constituent des parties étroites, allongées dans le sens de la diffusion de la lumière, d'une couche de semi-conducteur continue, cohérente ou d'un paquet de couches de semi-conducteurs continues, cohérentes.
